(19)

Europäisches
Patentamt
European
Patent Office
Office européen
des brevets

(11) **EP 2 413 498 A1**

(12) **EUROPEAN PATENT APPLICATION**

(43) Date of publication:
**01.02.2012 Bulletin 2012/05**

(51) Int Cl.:
**H03F 1/02** *(2006.01)* **H03F 1/56** *(2006.01)*
**H03F 3/60** *(2006.01)*

(21) Application number: **10171413.7**

(22) Date of filing: **30.07.2010**

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**
Designated Extension States:
**BA ME RS**

(71) Applicant: **NXP B.V.
5656 AG Eindhoven (NL)**

(72) Inventor: **DENG, Xiaobo
5656 AE, Eindhoven (NL)**

(74) Representative: **Schouten, Marcus Maria
NXP B.V.
IP & Licensing Department
High Tech Campus 60
5656 AG Eindhoven (NL)**

(54) **Doherty amplifier**

(57)    A Doherty amplifier (90,92) uses a power combiner component in which the output of the or each series phase shifting element of the output network (96) of the amplifier (90,92) is connected to a reference voltage line through a further phase shifting element (98).

FIG. 9

**Description**

The invention relates to an electronic device comprising a Doherty Amplifier ("DA") with an amplifier input and an amplifier output, wherein the amplifier has a main stage, and at least one peak stage.

An amplifier of this type has an input network connecting the amplifier input to a first input of the main stage and to a second input of the peak stage. An output network connects an output of the main stage and an output of the peak stage to the amplifier output.

A classical DA has two amplifying stages arranged in parallel and of the same power capability. The first one of the stages (main stage) operates in a class - AB amplifier mode and the second one (peak stage) operates in a class-C amplifier mode.

These stages are separated at their inputs and at their outputs by 90 degree phase shifting networks. The output phase shifting network has a specific characteristic impedance Zo which must be equal to the optimal load impedance RLm of the main stage. The input signal is split so as to drive the two amplifiers, and a summing network, known as an "impedance inverter" or a "Doherty combiner", is operative to:

    a) combine the two output signals,
    b) to correct for phase differences between the two output signals, and
    c) to provide an inverted impedance at the output of the DA with respect to the impedance as seen from the output of the main stage.

The DA addresses the problem than signals with significant amplitude modulation result in low average efficiency for the traditional power amplifier.

The classical DA is a so-called 2-way amplifier with a main stage and a single peak stage. A multi-way (or N-way) DA has a main stage and a plurality of peak stages operating in parallel. An advantage of a multi-way Doherty system is that it extends the back-off level far beyond the symmetrical 2-way design without exhibiting significant drop in efficiency between the efficiency peaking points. As a result, an improvement of efficiency is possible at 12dB power back-off, not at 6dB back-off as for a symmetrical 2-way DA. The 12dB power back-off is currently demanded by new communication systems such as 3 G-LTE (third generation long-term evolution) and WiMAX (Worldwide Interoperability for Microwave Access).

Typically, the main stage and the peak stages are implemented using a respective power transistor as each of the respective stages.

This invention relates equally to two-way or N-way DA designs.

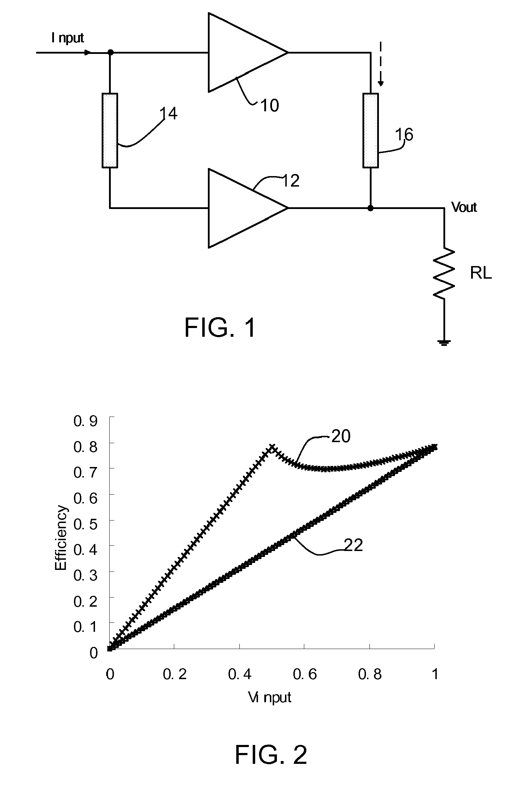

The classical two-way Doherty architecture as shown in Figure 1. Two Power Amplifiers; a main amplifier 10 and a peak amplifier 12 of equal power capacity, are driven by the input, with a $\lambda/4$ line 14 at the input of the peak amplifier 12. This functions as an impedance aligner. An impedance inverter 16 combines the output.

This design can be extended to N-ways to further improve the efficiency at deep back-off. For example, 3-way DAs are a standard power amplifier device.

Figure 2 shows the instantaneous efficiency of the 2-way Doherty power amplifier of Figure 1 (plot 20) as well as the efficiency of an ideal class-B amplifier (plot 22). The $\lambda/4$ line 14 dynamically modulates the load impedances of both main and peak amplifiers as the input power level changes, improving the efficiency at back-off as shown in Figure 2.

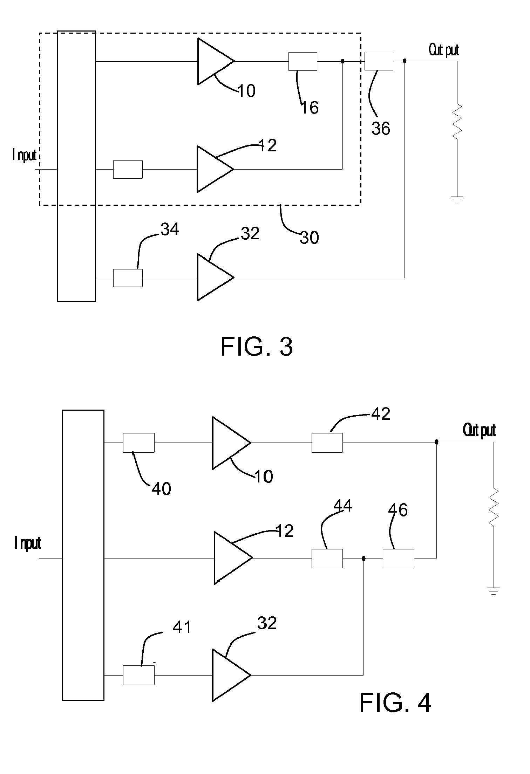

Figure 3 shows a conventional 3-way DA. The region 30 is the same as the 2-way design of Figure 1. A second peak amplifier 32 and $\lambda/4$ line 34 are connected between the input and output, and a second impedance inverter $\lambda/4$ line 36 is connected between the output and the output from the 2-way DA section 30. Thus, a further channel is essentially added in parallel to the 2-way design. There is a phase shift of 180 degrees between the output of the main amplifier 10 and the output, a phase shift of 90 degrees between the output of the first peak amplifier 12 and the output, and no phase shift between the output of the third peak amplifier and the output.

WO2009/081341A1 describes a modification to the 3-way Doherty design, and this modification is shown in Figure 4.

In this design, there is a phase shift of 90 degrees between the output of the main amplifier and the output, a phase shift of 180 degrees between the output of the first peak amplifier and the output, and a phase shift of 90 degrees between the output of the third peak amplifier and the output.

The input is connected to the main power amplifier 10 through a first phase shifter 40, the input is connected directly to the first peak power amplifier 12, and input is connected to the second peak power amplifier 32 through a second phase shifter 41. A first phase shifter 42 functioning as output combiner is between the main amplifier 10 and the output giving the 90 degree phase shift. Second and third phase shifters 44,46 functioning as output combiners are between the first peak amplifier 12 and the output giving the 180 degree phase shift. The output of the second peak amplifier 32 taps to the junction between the second and third phase shifters 44,46, so that the third phase shifter 46 is providing the desired 90 degree phase shift.

This design is shown to reduce non-linear behaviour and to improve the efficiency at large back-off. Reference is made to WO2009/081341 for further details.

It is known that a DA operates in limited bandwidth mainly because of the limitations of the narrowband power combiner or impedance inverter (the $\lambda/4$ lines in the output network). As a result, the efficiency decreases when the signal frequency deviates from the nominal frequency for which the $\lambda/4$ lines are designed.

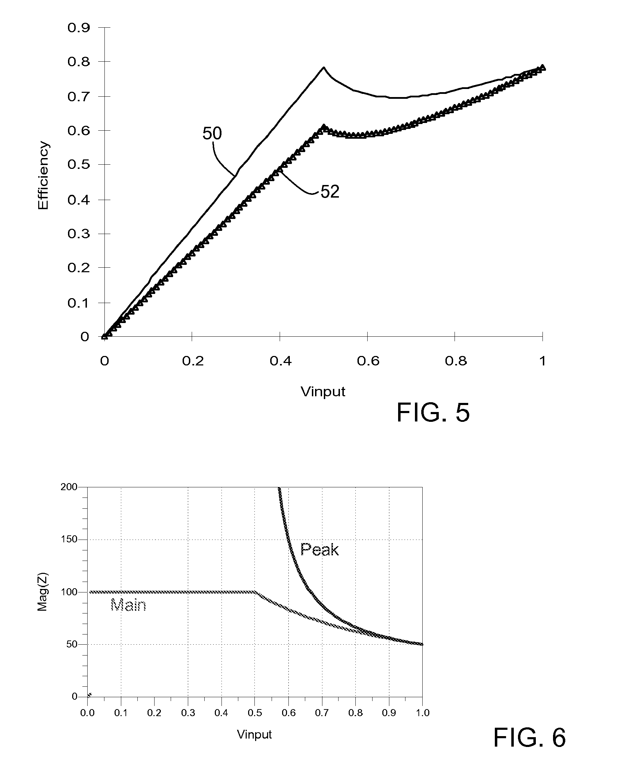

Figure 5 shows the instantaneous efficiency of a 2-way DA at $f_0$ (plot 50) and $1.2f_0$ (plot 52).

If the DA is amplifying a modulated signal (the power density function of such signal is represented by Rayleigh distribution), it can be considered that most of the time it is working in the back-off power region. In this region, the main power amplifier experiences a loading impedance which is double that of the nominal value.

Figure 6 shows the load impedance of the main and peak amplifier in a 2-way DA. Beyond the designed back-off point, the peak amplifier starts to work, resulting in dynamic change of the load impedances for both main and peak amplifiers. It is quite beneficial for the average efficiency improvement of a DA at different operation frequency if the two-times loading impedance of the main amplifier at back-off region can be maintained in a larger frequency range.

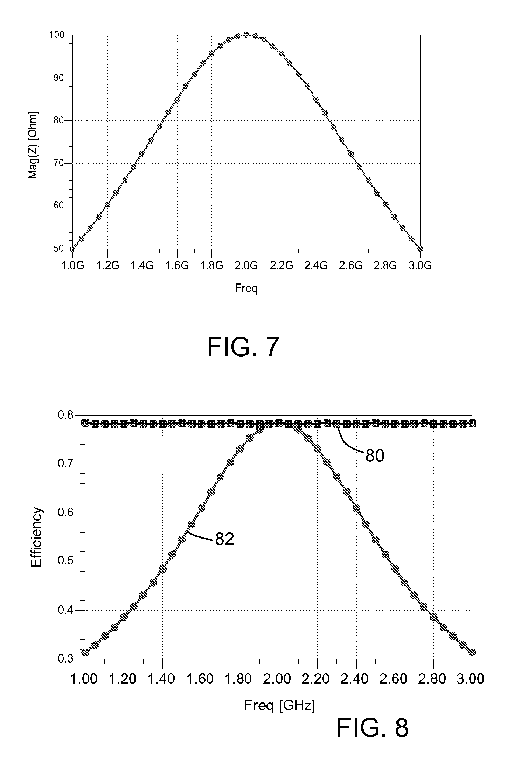

Figure 7 shows the impedance transformation properties of a λ/4 line, used in a 2-way Doherty power combiner, centred at 2 GHz. It transforms the load impedance to two times of the nominal value only at central frequency.

If a 10% DA efficiency drop is defined as the bandwidth criteria, the narrowest bandwidth is observed when the peak amplifier is off, which means 6dB back-off for a 2-way symmetrical DA. Figure 8 shows the efficiency of the 2-way DA as a function of frequency for full power operation (plot 80) and a 6dB back-off (plot 82). The 10% efficiency drop is maintained from 1.72GHz to 2.28GHz as shown in Figure 8, or a relative bandwidth of 28%.

The invention aims to improve the mentioned deficiency of the λ/4 line power combiner, allowing improved operation of the DA in the comparable frequency band or similar or better operation in significantly wider frequency bandwidth.

According to the invention, there is provided a Doherty amplifier comprising:

>a main amplifier;
>at least one peak amplifier;
>an input network connecting the Doherty amplifier input to the input of the main amplifier and to the input of the at least one peak stage; and
>an output network connecting an output of the main amplifier and an output of the at least one peak amplifier to the Doherty amplifier output,
>wherein the output network comprises at least one series phase shifting element between the output of the main amplifier or the output of the at least one peak amplifier and the Doherty amplifier output,
>and wherein the output of the at least one series phase shifting element is connected to a reference voltage line through a further phase shifting element.

The invention provides a modified design for the power combiner elements of the Doherty amplifier, in order to improve the amplifier response at frequencies adjacent the target frequency of operation. The reference voltage line can be ground. The (or each) series phase shifting element can comprise a λ/4 line (with respect to the desired frequency of operation) or an LC circuit, and the (or each) further phase shifting element comprises a λ/4 line or an LC circuit. The LC circuit is tuned to the desired frequency of operation and comprise parallel L and C elements.

The output network can comprise a plurality of phase shifting elements, and the output of each series phase shifting element being connected to the reference voltage line through a respective further phase shifting element. This means that any existing design of Doherty amplifier can be modified so that each impedance inverter/combiner element in the output network is modified in accordance with the invention.

The invention can be applied to a conventional 2-way Doherty amplifier, so that the modified version comprises:

>only one peak amplifier;
>only one series phase shifting element between the output of the main amplifier and the Doherty amplifier output; and
>only one further phase shifting element.

The Doherty amplifier input is connected directly to the input of the main amplifier, and the input network comprises an input phase shifting element between the Doherty amplifier input and the peak amplifier input.

The invention can be applied to a conventional 3-way Doherty amplifier, so that the modified version comprises:

>two peak amplifiers;
>first and second series phase shifting elements between the output of the main amplifier and the Doherty amplifier output, with the output of the first peak amplifier connected to the junction between the first and second series phase shifting elements, and the output of the second peak amplifier connected to the Doherty amplifier output with no phase shifting element.

The Doherty amplifier input is connected directly to the input of the main amplifier, and the input network comprises first and second input phase shifting elements, the first input phase shifting element between the Doherty amplifier input and the first peak amplifier input and the second input phase shifting element between the Doherty amplifier input and the second peak amplifier input.

The invention can be applied to the 3-way Doherty amplifier of WO2009/081341, so that the modified version comprises:

>two peak amplifiers;
>a first series phase shifting element between the output of the main amplifier and the Doherty amplifier output;
>second and third series phase shifting elements between the output of the first peak amplifier and the Doherty amplifier output, with the output of the second peak amplifier connected to the junction between the first and second series phase shifting elements.

The Doherty amplifier input is connected directly to the input of the first peak amplifier, and the input network comprises first and second input phase shifting elements, the first input phase shifting element between the Doherty amplifier input and the main amplifier input and the second input phase shifting element between the Doherty amplifier input and the second peak amplifier input.

In all cases, the input phase shifting elements each comprise a $\lambda/4$ line or an LC circuit.

Examples of the invention will now be described in detail with reference to the accompanying drawings, in which:

Figure 1 shows a classical two-way Doherty architecture;

Figure 2 shows the instantaneous efficiency of the 2-way DA of Figure 1 as well as the efficiency of an ideal class-B amplifier;

Figure 3 shows a conventional 3-way DA;

Figure 4 shows a 3-way DA of WO2009/081341A1;

Figure 5 shows the instantaneous efficiency of a 2-way DA at $f_0$ and $1.2f_0$;

Figure 6 shows the load impedance of the main and peak amplifiers in a 2-way DA;

Figure 7 shows the impedance transformation properties of a $\lambda/4$ line, used in a 2-way Doherty power combiner, centred at 2 GHz;

Figure 8 shows the efficiency of the 2-way DA as a function of frequency for full power operation and at 6dB back-off;

Figure 9 is used to explain the concept of the invention, based on a 2-way DA;

Figure 10a shows the impedance transformation effect of the modified power combiner of Figure 9;

Figure 10b shows how a 2$^{nd}$ harmonic short is provided;

Figure 11 gives an efficiency comparison of the DA with different power combiners;

Figure 12 shows how the impedance can be adjusted to tune the performance of the power combiner;

Figure 13 shows a modified version of the compensated power combiner;

Figure 14 shows the impedance transformation effect of the modified power combiner of Figure 13;

Figure 15 shows how the circuit can be adjusted to tune the performance of the power combiner;

Figure 16 shows how the conventional 3-way DA of Figure 3 is modified to provide the compensated power combiner of the invention; and

Figure 17 shows how the 3-way DA of Figure 4 is modified to make use of the compensated power combiner of the invention.

The invention provides a modified power combiner component, in particular in which the output of the (or each) series phase shifting element of the output network is connected to a reference voltage line through a further phase shifting element.

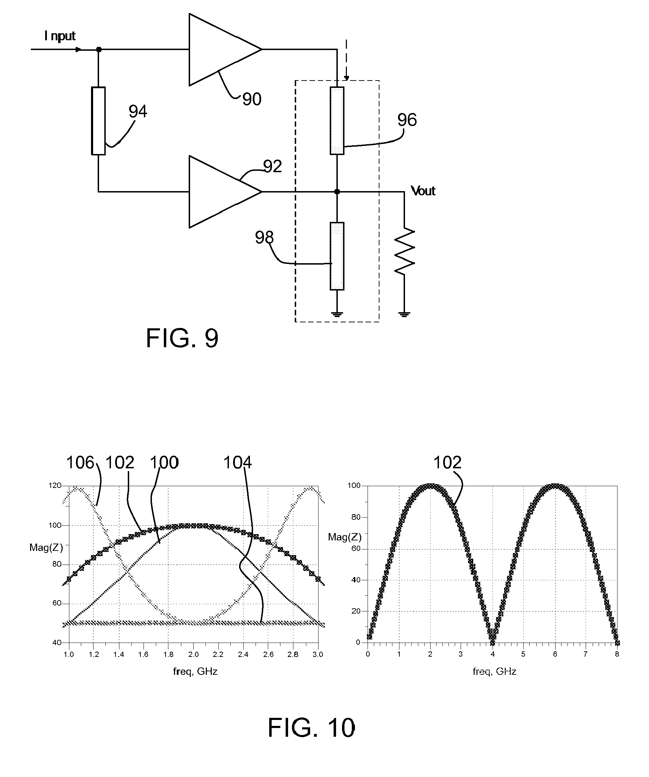

Figure 9 is used to explain the concept of the invention, based on a 2-way DA.

The DA comprises a main amplifier 90 connected to the input, and a single peak amplifier 92 connected to the input through a $\lambda/4$ line 94 performing a degree phase shift. The output is defined at the output of the peak amplifier 92, and another $\lambda/4$ line 96 functioning as a power combiner is between the output and the output of the main amplifier 90. The components described above are identical to the circuit of Figure 1. The DA of Figure 9 additionally comprises a further $\lambda/4$ line 98 connected between the output and ground.

The output stage this uses a combination of two $\lambda/4$ lines 96,98, which can be considered to function as a compensated power combiner.

The $\lambda/4$ line 98 is thus short circuited to ground and has a characteristic impedance of Zt. The impedance transformation effect of the modified power combiner is shown in Figure 10a.

Plot 100 shows the impedance function for the known $\lambda/4$ line (corresponding to Figure 7) for a load impedance of 100$\Omega$. Plot 102 shows the same impedance function for the compensated impedance inverter of the invention. As can be seen, the response is much flatter over frequency.

Plot 104 shows the impedance function for the known $\lambda/4$ line for a load impedance of 50$\Omega$. Plot 106 shows the corresponding impedance function for the compensated impedance inverter of the invention.

Figure 10 shows that the compensated power combiner can invert the load impedance to two times of nominal value (i.e. to 100$\Omega$) in a larger bandwidth.

This technique provides an extra benefit, in that a 2$^{nd}$ harmonic short is provided for RF signals which can further improve the efficiency. This is shown in Figure 10b, which is plot 102 over a larger bandwidth. The price to pay is the non-nominal impedance value when load impedance changes to (for example) 50$\Omega$ as the operation frequency deviates from the centre.

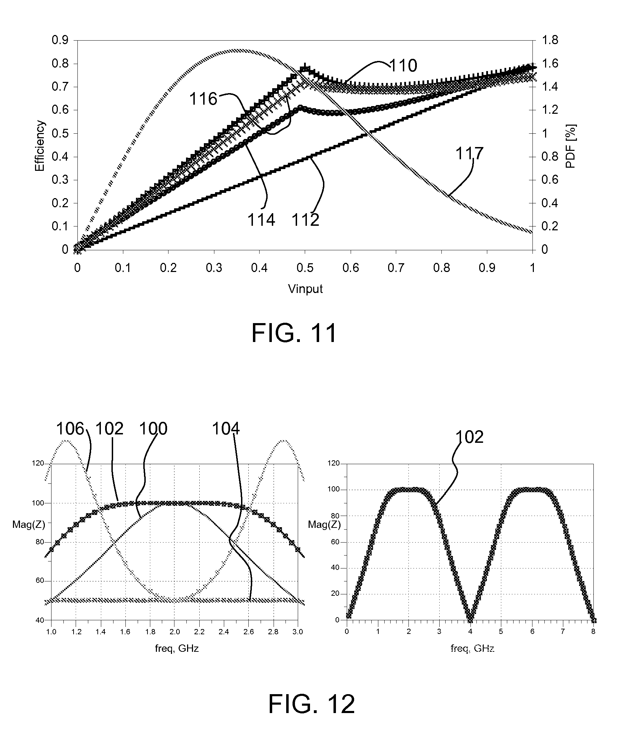

Figure 11 enables an efficiency comparison of the DA with different power combiners (WCDMA signals PAR=6dB). The efficiency is plotted against input voltage.

Plot 110 shows the efficiency of the standard 2-way DA at the designed operating frequency ($f_0$). Plot 112 shows the efficiency of a class B amplifier. These two plots correspond to Figure 2.

Plot 114 shows the efficiency of the standard 2-way DA at $1.2f_0$, and plot 116 shows the efficiency of the 2-way DA of the invention at $1.2f_0$.

Plot 117 is the Rayleigh distribution.

When the operation frequency deviates by $0.2f_0$, the DA with compensated power combiners shows more than 10% efficiency improvement over the original DA. Since most of the time the DA is working in the back-off region if a digitally modulated signal is applied, the average efficiency improvement in the comparable frequency band or similar or wider frequency bandwidth is achieved. The average efficiency calculation result shows that there is 7% improvement from 0.45 to 0.52 at $1.2f_0$ when a WCDMA signal with 6dB PAR(peak to average power ratio) is applied to the DA based on the compensated power combiner of the invention.

The impedance of the short-circuited λ/4 line can be adjusted to tune the performance of the power combiner as shown in Figure 12, which shows the compensated power combiner performance optimized for a flat double load impedance (100Ohm) The plots 102, 104, 106, 108 correspond to those in Figure 10, but with a modified impedance of the line 98.

In Figure 9, there is only one more phase shifter 98 compared to Figure 1. The phase shifter 94 at the input and the impedance inverter 96 are both 50 Ohm (Z0) while the load impedance is transformed to 25 Ohm by a quarter wavelength transmission line from 50 Ohm, which is the industrial default. Phase shifter 98 is added to compensate the original impedance inverter's frequency behaviour. Its impedance value can be tuned to get flatter impedance inversion performance, which is effective in the range of [0.6Z0 - 1.5Z0]. The flattest response at double load impedance is obtained when the impedance of the phase shifter 98 is 0.73 Z0

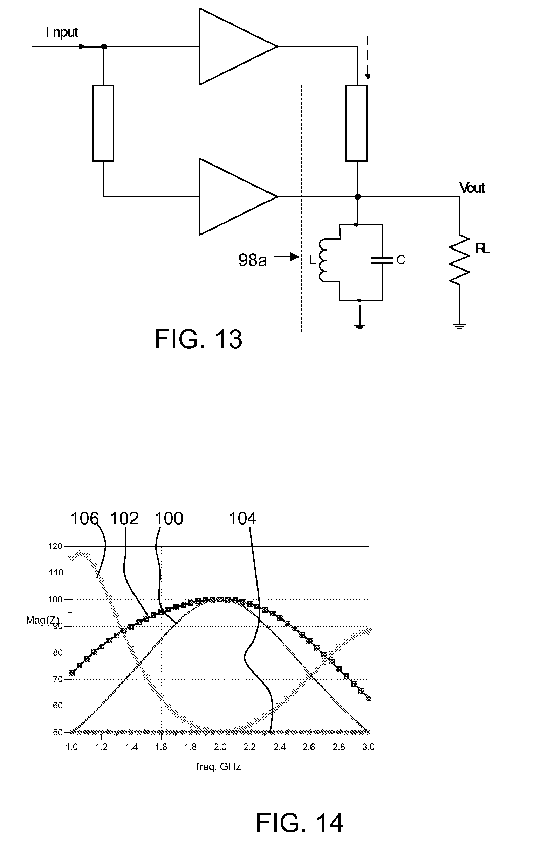

Figure 13 shows a modified version of the compensated power combiner.

In this design, the original short circuited line in Figure 9 is replaced by a LC tank 98a (i.e. a capacitor and inductor in parallel with each other, and the parallel combination between the output of the DA and ground) with a resonance frequency at the central frequency of the short circuited line. The load impedance and the LC tank form a RLC network. The property of this topology is the same as that of the original one at central frequency.

With the relation $f_0 = \dfrac{1}{2\pi\sqrt{LC}}$ unaltered, the Q factor of this network can be tuned by choosing different L and C values to get different performances. The impedance transformation effect of this modified power combiner is shown in Figure 14. The plots 100,102,104,106 again correspond to those in Figure 10, but with the modified design of power combiner as shown in Figure 13.

Figure 14 shows that the modified compensated power combiner of Figure 13 again has larger bandwidth when transforming the load impedance to two times the nominal value. It has a similar function to the compensated power combiner of Figure 10 when the load is the nominal value. However, it can not provide the 2nd

harmonic short. Also the impedance function is not symmetrical with the central frequency.

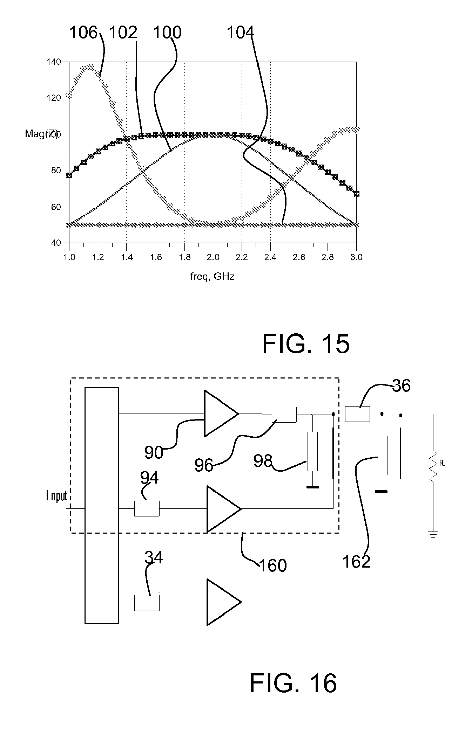

Figure 15 shows how the function can be optimized for flat double load, and shows the same plots.

The flattest response in Figure 15 is obtained when L=4.052nH, C=1.563pF. If the capacitance value is used as the reference, the flatter response compared to the original quarter wavelength transmission line can be observed by increasing the capacitance from a low value, for example C=0.3pF, with the inductance modified so as the LC resonance frequency is kept at the central frequency. A flatter response can be observed as C increases until C=1.563pF where the flattest response is obtained. When C is further increased, the inverted impedance at double load impedance will become larger than 100 Ohm at other frequencies than the central frequency.

The invention can be applied to 3-way DAs.

Figure 16 shows how the conventional 3-way DA of Figure 3 is modified to provide the compensated power combiner of the invention.

The components 160 correspond to the 2-way design of Figure 9, including the additional phase shifter 98 between the output of the 2-way section 160 and ground.

In addition, a second additional phase shifter 162 is provided between the output and ground.

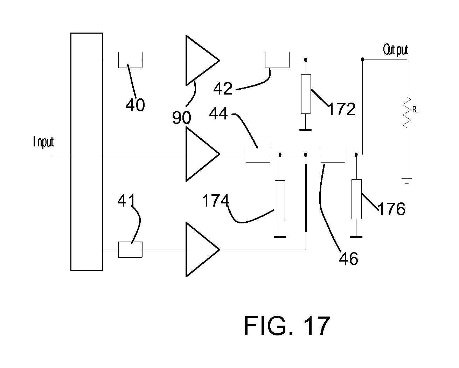

Figure 17 shows how the 3-way DA of Figure 4 is modified to make use of the compensated power combiner of the invention.

Each of the output combiners 42,44,46 is provided with a coupling to ground at their output, in the form of a λ/4 line 172,174,176.

The shunt short circuited lines shown in Figures 16 and 17 can be replaced with an LC tank whose resonance frequency is the central frequency.

Essentially, each standard combiner phase shifter (i.e. of the known designs) at the output of the main or peak amplifiers is supplemented by further phase shifter between the output of the standard phase shifter and ground. These further phase shifters can be in the form of a short circuit λ/4 line to ground or in the form of an LC circuit to ground. This approach can be applied to known 2-way or 3-way DA designs, or indeed to N-way designs where N>3.

The additional phase shifting elements can be identical to the existing phase shifting elements in the design, and they are tuned to the same frequency. The phase shifting elements can be considered to be impedance transforming elements, and they comprise complex impedances - typically either a transmission line or lumped elements which function as a transmission line.

The invention may be used to improve the performance of high efficiency DAs. Significant gains in average efficiency can be achieved.

The invention can be applied to any DA design which uses a network of phase shifting elements to construct the output signal. The phase shifting elements can be modified as explained above by providing a further path to ground. The invention is thus not limited to the three examples above.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. Any reference signs in the claims should not be construed as limiting the scope.

**Claims**

1. A Doherty amplifier comprising:

   a main amplifier (90);
   at least one peak amplifier (92);
   an input network (94) connecting the Doherty amplifier input to the input of the main amplifier and to the input of the at least one peak stage; and
   an output network (96) connecting an output of the main amplifier (90) and an output of the at least one peak amplifier (92) to the Doherty amplifier output,
   wherein the output network comprises at least one series phase shifting element (96) between the output of the main amplifier (90) or the output of the at least one peak amplifier (92) and the Doherty amplifier output,
   and wherein the output of the at least one series phase shifting element (96) is connected to a reference voltage line through a further phase shifting element (98).

2. An amplifier as claimed in claim 1, wherein the reference voltage line is ground.

3. An amplifier as claimed in any preceding claim, wherein the or each series phase shifting element (96) comprises a $\lambda/4$ line or an LC circuit, and the or each further phase shifting element (98) comprises a $\lambda/4$ line or an LC circuit (98a).

4. An amplifier as claimed in any preceding claim, wherein the output network comprises a plurality of phase shifting elements (96,36; 42,44,46) and the output of each series phase shifting element (96,36; 42,44,46) is connected to the reference voltage line through a respective further phase shifting element (98,162;172,174,176).

5. An amplifier as claimed in any one of claims 1 to 3, comprising a 2-way Doherty amplifier, comprising:

   only one peak amplifier (92);
   only one series phase shifting element (96) between the output of the main amplifier (90) and the Doherty amplifier output; and
   only one further phase shifting element (98).

6. An amplifier as claimed in claim 5, wherein the Doherty amplifier input is connected directly to the input of the main amplifier (90), and the input network comprises an input phase shifting element (94) between the Doherty amplifier input and the input of the peak amplifier (92).

7. An amplifier as claimed in claim 6, wherein the input phase shifting element (94) comprises a $\lambda/4$ line or an LC circuit.

8. An amplifier as claimed in any one of claims 1 to 4, comprising a 3-way Doherty amplifier, comprising:

   two peak amplifiers;
   first and second series phase shifting elements (96,36) between the output of the main amplifier and the Doherty amplifier output, with the output of the first peak amplifier connected to the junction between the first and second series phase shifting elements (96,36), and the output of the second peak amplifier connected to the Doherty amplifier output with no phase shifting element.

9. An amplifier as claimed in claim 8, wherein the Doherty amplifier input is connected directly to the input of the main amplifier (90), and the input network comprises first and second input phase shifting elements, the first input phase shifting element (94) between the Doherty amplifier input and the first peak amplifier input and the second input phase shifting element (34) between the Doherty amplifier input and the second peak amplifier input.

10. An amplifier as claimed in claim 9, wherein the input phase shifting elements (94,34) each comprise a $\lambda/4$ line or an LC circuit.

11. An amplifier as claimed in any one of claims 1 to 4, comprising a 3-way Doherty amplifier, comprising:

   two peak amplifiers;
   a first series phase shifting element (42) between the output of the main amplifier (90) and the Doherty amplifier output;
   second and third series phase shifting elements (44,46) between the output of the first peak amplifier and the Doherty amplifier output, with the output of the second peak amplifier connected to the junction between the first and second series phase shifting elements (44,46).

12. An amplifier as claimed in claim 11, wherein the Doherty amplifier input is connected directly to the input of the first peak amplifier, and the input network comprises first and second input phase shifting elements (40,41), the first input phase shifting element (41) between the Doherty amplifier input and the main amplifier input and the second input phase shifting element (41) between the Doherty amplifier input and the second peak amplifier input.

13. An amplifier as claimed in claim 12, wherein the input phase shifting elements (40,41) each comprise a λ/4 line or an LC circuit.

FIG. 1

FIG. 2

FIG. 3

FIG. 4

FIG. 5

FIG. 6

FIG. 7

FIG. 8

FIG. 9

FIG. 10

FIG. 11

FIG. 12

Input

98a →

Vout

L    C

RL

FIG. 13

106  102  100      104

Mag(Z)

freq, GHz

FIG. 14

FIG. 15

FIG. 16

FIG. 17

Europäisches
Patentamt

European
Patent Office

Office européen
des brevets

## EUROPEAN SEARCH REPORT

Application Number

EP 10 17 1413

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2006/003608 A1 (KONINKL PHILIPS ELECTRONICS NV [NL]; BLEDNOV IGOR [NL]) 12 January 2006 (2006-01-12) * page 7, line 11 - page 8, line 6; figure 2 * * page 9, lines 1-17; figure 5 * ----- | 1-4,8-10 | INV. H03F1/02 H03F1/56 H03F3/60 |
| X,D | WO 2009/081341 A1 (NXP BV [NL]; GAJADHARSING RADJINDREPERSAD [NL]) 2 July 2009 (2009-07-02) | 1-4, 11-13 | |
| A | * page 6, line 18 - page 9, line 21; figures 1,3,6 * ----- | 8-10 | |
| X | ECCLESTON K W: "Analysis of a multi-transistor interleaved Doherty amplifier", MICROWAVE CONFERENCE, 2009. APMC 2009. ASIA PACIFIC, IEEE, PISCATAWAY, NJ, USA, 7 December 2009 (2009-12-07), pages 1581-1584, XP031613321, ISBN: 978-1-4244-2801-4 * page 1581, left-hand column, line 38 - page 1582, left-hand column, line 14; figures 1,2 * ----- | 1-4 | |
| X | WO 2007/122586 A2 (KONINKL PHILIPS ELECTRONICS NV [NL]; BLEDNOV IGOR [NL] NXP BV [NL]; BL) 1 November 2007 (2007-11-01) * page 9, lines 1-28; figures 6,7 * ----- | 1-3,5-7 | TECHNICAL FIELDS SEARCHED (IPC) H03F |
| X | WO 2004/017512 A1 (KONINKL PHILIPS ELECTRONICS NV [NL]; BLEDNOV IGOR I [NL]) 26 February 2004 (2004-02-26) * page 10, lines 18-31; figure 7 * ----- | 1-4 | |

The present search report has been drawn up for all claims

| Place of search | Date of completion of the search | Examiner |
|---|---|---|
| The Hague | 18 February 2011 | Fedi, Giulio |

EPO FORM 1503 03.82 (P04C01)

**ANNEX TO THE EUROPEAN SEARCH REPORT
ON EUROPEAN PATENT APPLICATION NO.**                    EP 10 17 1413

This annex lists the patent family members relating to the patent documents cited in the above-mentioned European search report.
The members are as contained in the European Patent Office EDP file on
The European Patent Office is in no way liable for these particulars which are merely given for the purpose of information.

18-02-2011

| Patent document cited in search report | | Publication date | Patent family member(s) | | Publication date |
|---|---|---|---|---|---|
| WO 2006003608 | A1 | 12-01-2006 | CN | 1977447 A | 06-06-2007 |
| | | | EP | 1763921 A1 | 21-03-2007 |
| | | | JP | 2008505521 T | 21-02-2008 |
| | | | US | 2009212858 A1 | 27-08-2009 |
| WO 2009081341 | A1 | 02-07-2009 | CN | 101904089 A | 01-12-2010 |
| | | | EP | 2235820 A1 | 06-10-2010 |
| | | | KR | 20100094589 A | 26-08-2010 |
| | | | US | 2010315162 A1 | 16-12-2010 |
| WO 2007122586 | A2 | 01-11-2007 | CN | 101617403 A | 30-12-2009 |
| | | | EP | 2013943 A2 | 14-01-2009 |
| | | | JP | 2009539277 T | 12-11-2009 |
| | | | US | 2009174482 A1 | 09-07-2009 |
| WO 2004017512 | A1 | 26-02-2004 | AU | 2003247109 A1 | 03-03-2004 |
| | | | CN | 1675826 A | 28-09-2005 |
| | | | EP | 1532731 A2 | 25-05-2005 |
| | | | JP | 2005536922 T | 02-12-2005 |
| | | | KR | 20050046731 A | 18-05-2005 |
| | | | US | 2005231278 A1 | 20-10-2005 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2009081341 A1

- WO 2009081341 A